# FASCICULE DE BREVET EUROPEEN

(11) **EP 3 070 752 B1**
(45) Date de publication et mention de la délivrance du brevet: **10.04.2019**
(21) Numéro de dépôt: 16160762.7
(22) Date de dépôt: 16.03.2016
(51) Int. Cl.: H01L 33/00, H01L 33/60, H01L 33/62, H01L 33/50, H01L 27/15, H01L 33/64, H01L 33/20, H01L 33/08, H01L 33/22, H01L 33/38

(54) **PROCÉDÉ DE FABRICATION DE DISPOSITIF OPTOÉLECTRONIQUE À DIODE ÉLECTROLUMINESCENTE**
VERFAHREN ZUR HERSTELLUNG EINER OPTOELEKTRONISCHEN VORRICHTUNG MIT EINER LEUCHTDIODE
PROCESS OF MANUFACTURING OF AN OPTOELECTRONIC DEVICE WITH A LIGHT-EMITTING DIODE

(30) Priorité: 20.03.2015 FR 1552348
(43) Date de publication de la demande: 21.09.2016
(73) Titulaire: COMMISSARIAT À L'ÉNERGIE ATOMIQUE ET AUX ÉNERGIES ALTERNATIVES, 75015 Paris (FR)
(72) Inventeur: BONO, Hubert, 38000 GRENOBLE (FR); ROBIN, Ivan-Christophe, 38000 GRENOBLE (FR)
(74) Mandataire: Cabinet Beaumont

(56) Documents cités:
- WO-A1-2011/108664
- WO-A2-2012/164437
- US-A1- 2010 244 065

## Description

### Domaine

La présente invention concerne un procédé de fabrication d'un dispositif optoélectronique comprenant au moins une diode électroluminescente.

### Exposé de l'art antérieur

De façon générale, la fabrication d'un dispositif optoélectronique à diode électroluminescente comprend la fabrication de diodes électroluminescentes sur un substrat qui est ensuite découpé en puces individuelles. Chaque puce individuelle est alors montée sur un support. Différents éléments peuvent, en outre, être fixés à la puce individuelle ou au support pour réaliser diverses fonctions dont notamment la transformation du rayonnement électromagnétique émis par la diode électroluminescente en un rayonnement ayant le spectre souhaité, l'évacuation de la chaleur fournie par la diode électroluminescente, la commande électrique de la diode électroluminescente, la connexion électrique du dispositif optoélectronique à un système externe et la protection du dispositif vis-à-vis du milieu extérieur.

Les divers procédés connus de fabrication, d'encapsulation et de montage de diodes électroluminescentes impliquent la mise en oeuvre de très nombreuses étapes dont certaines sont complexes, impliquant notamment des reports de puces et l'utilisation de poignées multiples. L'état de la technique sur les procédés de fabrication de dispositifs optoélectroniques à diodes électroluminescentes comprend les documents WO 2011/108664 A1, US 2010/244065 A1 et WO 2012/164437 A2.

### Résumé

Un objet d'un mode de réalisation vise à pallier tout ou partie des inconvénients des procédés de fabrication de dispositifs optoélectroniques à diodes électroluminescentes décrits précédemment.

Un autre objet d'un mode de réalisation est que la fabrication et l'encapsulation des diodes électroluminescentes soient réalisées de façon collective par un procédé qui soit particulièrement simple à mettre en oeuvre et qui assure que le montage des diodes électroluminescentes puisse se faire dans des conditions optimales de dissipation thermique.

Ainsi, un mode de réalisation prévoit un procédé de fabrication de dispositifs optoélectroniques à diodes électroluminescentes comprenant les étapes suivantes :
a) former une première puce de circuit intégré comprenant des diodes électroluminescentes ;
b) coller une deuxième puce de circuit intégré à une première face de la première puce de circuit intégré ;
c) réduire l'épaisseur de la première puce de circuit intégré du côté opposé à la première face jusqu'à former une deuxième face opposée à la première face, la première puce de circuit intégré ayant, après l'étape c), une première épaisseur comprise entre 100 nm et 50 µm ;
d) coller, à la deuxième face, un capot comprenant une plaquette de silicium munie d'évidements en regard des diodes électroluminescentes, le capot comprenant éventuellement, en outre, une plaque transparente fixée à la plaquette de silicium, les étapes b), c) et d) étant successives ;
e) réduire l'épaisseur de la deuxième puce de circuit intégré, la deuxième puce de circuit intégré ayant une deuxième épaisseur inférieure ou égale à 150 µm après l'étape e) ;
f) réduire l'épaisseur de la plaquette de silicium après l'étape e), l'épaisseur du capot, comprenant éventuellement la plaque transparente, étant supérieure ou égale à 100 µm après l'étape f), chaque évidement étant rempli d'un matériau photoluminescent ; et
g) découper la structure obtenue à l'étape f) en plusieurs dispositifs optoélectroniques distincts comprenant chacun au moins l'une des diodes électroluminescentes.

Selon un mode de réalisation, les diodes électroluminescentes ont une structure mesa.

Selon un mode de réalisation, les évidements sont remplis du matériau photoluminescent avant l'étape d).

Selon un mode de réalisation, les évidements sont non traversants avant l'étape f), et sont traversants après l'étape f), le procédé comprenant, en outre, l'étape de remplissage de chaque évidement du matériau photoluminescent après l'étape f).

Selon un mode de réalisation, l'étape a) comprend la formation des diodes électroluminescentes sur un substrat et l'étape c) comprend le retrait, partiel ou complet, du substrat.

Selon un mode de réalisation, la deuxième puce de circuit intégré est fixée à la première puce de circuit intégré par collage direct et est reliée électriquement aux diodes électroluminescentes.

Un mode de réalisation illustratif, qui ne fait pas partie de l'invention revendiquée, prévoit également un dispositif optoélectronique comprenant :
une première puce de circuit intégré comprenant des première et deuxième faces opposées, ayant une épaisseur comprise entre 100 nm et 50 µm et comprenant au moins une diode électroluminescente ;
un capot fixé à la première face, le capot comprenant au moins un évidement traversant délimité par un cadre en silicium et contenant un bloc d'un matériau photoluminescent, le capot comprenant, en outre, éventuellement une plaque transparente, l'épaisseur du capot, comprenant éventuellement la plaque transparente, étant supérieure ou égale à 100 µm ; et
une deuxième puce de circuit intégré fixée à la deuxième face et ayant une épaisseur inférieure ou égale à 150 µm.

Selon un mode de réalisation illustratif, qui ne fait pas partie de l'invention revendiquée, la diode électroluminescente a une structure mesa.

Selon un mode de réalisation illustratif, qui ne fait pas partie de l'invention revendiquée, le bloc photoluminescent est entouré latéralement par une paroi réfléchissante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 7 sont des vues avec coupe, partielles et schématiques, de modes de réalisation d'un dispositif optoélectronique, qui ne fait pas partie de l'invention revendiquée ;
les figures 8A à 8N sont des vues avec coupe, partielles et schématiques, de structures obtenues à des étapes successives d'un mode de réalisation d'un procédé de fabrication du dispositif optoélectronique représenté en figure 1 ; et
les figures 9A à 9D sont des vues avec coupe, partielles et schématiques, de structures obtenues à des étapes successives d'un mode de réalisation d'un procédé de fabrication du dispositif optoélectronique représenté en figure 7.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. En outre, dans la suite de la description, les expressions "sensiblement", "environ" et "approximativement" signifient "à 10 % près". En outre, seuls les éléments utiles à la compréhension de la présente description ont été représentés et sont décrits. En particulier, les moyens de polarisation d'une diode électroluminescente d'un dispositif optoélectronique sont bien connus et ne sont pas décrits.

Dans la suite de la description, on appelle "zone active" d'une diode électroluminescente la région de la diode électroluminescente depuis laquelle est émise la majorité du rayonnement électromagnétique fourni par la diode électroluminescente.

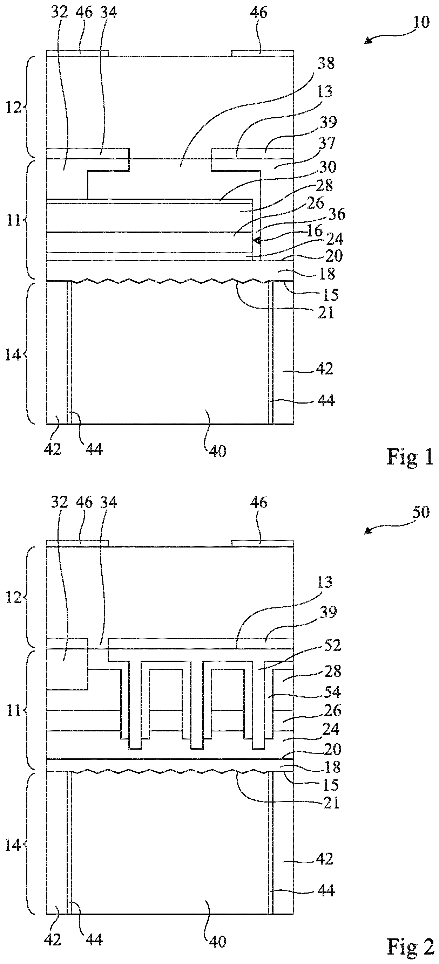

La figure 1 représente un mode de réalisation d'un dispositif optoélectronique 10 comprenant une diode électroluminescente.

Le dispositif 10 comprend une première puce de circuit intégré 11, une deuxième puce de circuit intégré 12 fixée à une première face 13 de la puce 11 et un capot 14 fixé à une deuxième face 15 de la puce 11, opposée à la première face 13. En fonctionnement, le dispositif 10 est adapté à émettre un rayonnement électromagnétique depuis la puce optoélectronique 11 au travers du capot 14, c'est-à-dire vers le bas en figure 1.

La première puce de circuit intégré 11 comprend au moins une diode électroluminescente 16 et est appelée circuit optoélectronique ou puce optoélectronique dans la suite de la description. En figure 1, le dispositif optoélectronique représenté ne comprend qu'une seule diode électroluminescente 16. La deuxième puce de circuit intégré 12 assure la connexion entre la puce optoélectronique 11 et un support, non représenté, du dispositif disposé du côté de la deuxième puce de circuit intégré 12 opposé à celui sur lequel est montée la puce optoélectronique 11. La deuxième puce de circuit intégré 12 peut comprendre des composants électroniques, non représentés, notamment des transistors, utilisés pour la commande ou la protection de la diode électroluminescente 16 de la première puce de circuit intégré 11. La deuxième puce de circuit intégré 12 est appelée interposeur ou puce de commande dans la suite de la description. La puce optoélectronique 11 est fixée à l'interposeur 12. Selon le type de fixation, des inserts peuvent être éventuellement présents entre la puce optoélectronique 11 et l'interposeur 12.

L'épaisseur de la puce optoélectronique 11 est comprise entre 100 nm et 50 µm, de préférence entre 1 µm et 30 µm, par exemple environ 10 µm. L'épaisseur de l'interposeur 12 est inférieure ou égale à 150 µm, de préférence comprise entre 1 µm et 150 µm, plus préférentiellement comprise entre 10 µm et 100 µm par exemple environ 30 µm. Le capot 14 peut comprendre une plaque transparente, par exemple une plaque de verre. L'épaisseur du capot 14, comprenant l'éventuelle plaque transparente, est supérieure ou égale à 100 µm.

Selon un mode de réalisation, la diode électroluminescente 16 comprend un empilement de couches semiconductrices contenant chacune majoritairement au moins un composé III-V. Selon un premier exemple, la diode électroluminescente 16 a la structure décrite dans la demande de brevet EP2960940 qui est considérée comme faisant partie intégrante de la présente description. Selon un deuxième exemple, la diode électroluminescente 16 a la structure décrite dans la publication intitulée "III-nitride micro-emitter arrays: development and applications" aux noms de Z.Y. Fan, J.Y. Lin, et H.X. Jiang (Journal of Physics D: Applied Physics, volume 41, numéro 9, pages 094001, 2008). Selon un mode de réalisation, la diode électroluminescente 16 a une structure bidimensionnelle, également appelée structure mesa, dans la mesure où elle est réalisée par un empilement de couches semiconductrices sensiblement planes et comprend une zone active qui se trouve en saillie au-dessus du substrat suite à une étape de gravure de ses flancs.

Selon un mode de réalisation, la puce optoélectronique 11 comprend une couche 18 semiconductrice délimitée par la face 15 et une face 20 opposée. La diode électroluminescente 16 repose sur la face 20 de la couche 18. La couche 18 est, par exemple, une couche semiconductrice fortement dopée d'un premier type de conductivité, par exemple de type N. La couche 18 est, par exemple, en un composé III-V, notamment un composé III-N. Des exemples de composés III-N sont GaN, AlN, InN, InGaN, AlGaN ou AlInGaN. L'épaisseur de la couche 18 peut être comprise entre 500 nm et 50 µm, de préférence entre 1 µm et 6 µm. La face 15 peut comprendre des motifs 21 en relief qui améliorent l'extraction de la lumière émise par la diode électroluminescente 16. L'épaisseur maximale des motifs en relief 21 peut être supérieure à 500 nm. La densité des motifs peut être supérieure à 10⁷/cm².

La diode électroluminescente 16 comprend un empilement de portions de couches semiconductrices comportant, du bas vers le haut en figure 1 :
une portion semiconductrice 24 dopée du premier type de conductivité, par exemple dopée de type N, au contact de la face 20 de la couche 18 ;
une zone active 26 ; et
une portion semiconductrice 28 dopée d'un deuxième type de conductivité opposé au premier type de conductivité, par exemple dopée de type P.

Selon un autre mode de réalisation, la couche semiconductrice 18 peut ne pas être présente.

Selon un mode de réalisation, la zone active 26 et les portions semiconductrices 24 et 28 comprennent chacune majoritairement au moins un composé III-V, notamment un composé III-N. Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. La zone active 26 et les portions semiconductrices 24 et 28 peuvent comprendre chacune un dopant.

La zone active 26 peut comprendre un puits quantique unique. Elle peut alors comprendre un matériau semiconducteur différent du matériau semiconducteur formant les portions semiconductrices 24 et 28 et ayant une bande interdite inférieure à celle des portions semiconductrices 24 et 28. La zone active 26 peut comprendre des puits quantiques multiples. Elle comprend alors un empilement de couches semiconductrices formant une alternance de puits quantiques et de couches barrières.

L'épaisseur de la portion semiconductrice 24 peut être comprise entre 0,1 µm et 20 µm. L'épaisseur de la portion semiconductrice 28 peut être comprise entre 50 nm et 20 µm. L'épaisseur de la zone active 26 peut être comprise entre 10 nm et 500 nm. La largeur de la diode électroluminescente 16 peut être inférieure à 30 µm, de préférence de 5 µm à 30 µm.

Pour chaque diode électroluminescente 16, une portion conductrice électriquement 30 recouvre la portion semiconductrice 28. Les portions conductrices 30 sont, par exemple, en aluminium ou en argent. L'épaisseur de chaque portion conductrice 30 est, par exemple, comprise entre 3 nm et 400 nm. La puce optoélectronique 11 comprend un élément de connexion 32 qui relie électriquement la portion conductrice 30 à l'interposeur 12. L'interposeur 12 comprend une portion conductrice 34 au contact de l'élément de connexion 32.

Les flancs latéraux de la portion semiconductrice 28, de la zone active 26 et au moins d'une partie de la portion semiconductrice 24 sont recouverts d'une portion isolante 36. L'épaisseur de la portion isolante 36 peut être choisie de façon que la portion isolante 36 présente un courant de fuite acceptable.

La puce optoélectronique 11 comprend un élément de connexion 37 qui relie électriquement la couche 18 à une portion conductrice 39 de l'interposeur 12. L'élément de connexion 37 est isolé électriquement de la portion semiconductrice 28 et de la zone active 26 par la portion isolante 36. L'élément de connexion 37 est au contact de la face 20 de la couche 18. L'élément de connexion 37 peut, en outre, être au contact d'une partie de la portion semiconductrice 24. Les éléments de connexion 32 et 37 sont isolés électriquement l'un de l'autre par une région isolante 38 qui prolonge la portion isolante 36. Les éléments de connexion 32, 37 et la région isolante 38 délimitent la face 13 de la puce optoélectronique 11.

Le capot 14 comprend au moins un bloc photoluminescent 40 sur la face 15 de la couche 18 en vis-à-vis de la diode électroluminescente 16, un seul bloc photoluminescent 40 étant représenté en figure 1. Le bloc photoluminescent 40 est entouré d'un cadre 42 reposant sur la face 15 de la couche 18. Le cadre 42 peut être réalisé en un matériau isolant, semiconducteur ou conducteur. A titre d'exemple, le cadre 42 est en silicium. L'épaisseur du bloc photoluminescent 40 est comprise entre 50 µm et 200 µm, de préférence comprise entre 75 µm et 150 µm, par exemple d'environ 100 µm. La largeur du bloc photoluminescent 40 est comprise entre 20 µm et 200 µm, de préférence entre 75 µm et 150 µm, par exemple d'environ 100 µm. Le bloc photoluminescent 40 peut comprendre un matériau photoluminescent, comprenant, par exemple, une matrice dans laquelle sont dispersés des luminophores, par exemple du grenat d'yttrium et d'aluminium (YAG, sigle anglais pour Yttrium Aluminium Garnet) activé par l'ion cérium trivalent, également appelé YAG:Ce ou YAG:Ce³⁺.

Selon un mode de réalisation, les parois latérales du cadre 42 orientées vers le bloc photoluminescent 40 sont recouvertes d'un revêtement 44 adapté à réfléchir le rayonnement émis par les blocs photoluminescents 40. Le revêtement 44 est, par exemple, un film d'aluminium ayant une épaisseur comprise entre 10 nm et 2 µm.

De préférence, l'interposeur 12 est principalement en un matériau bon conducteur de la chaleur. Selon un mode de réalisation, l'interposeur 12 comprend principalement un substrat semiconducteur. L'interposeur 12 peut comprendre des portions conductrices 46 du côté opposé à la puce optoélectronique 11 pour permettre la connexion mécanique et/ou électrique de l'interposeur 12 à un support, non représenté. Selon un mode de réalisation, l'interposeur 12 comprend un élément de connexion, non représenté, reliant la portion conductrice 34 à l'une des portions conductrices 46 et un élément de connexion, non représenté, reliant la portion conductrice 34 à une autre des portions conductrices 46. Selon un mode de réalisation, l'interposeur 12 comprend un substrat semiconducteur et les éléments de connexion comprennent des vias conducteurs, isolés du substrat, et traversant le substrat sur toute son épaisseur. Selon un autre mode de réalisation, l'interposeur 12 comprend des composants électroniques, notamment des transistors, pour réaliser des fonctions particulières, par exemple la commande de la diode électroluminescente 16 ou la protection de la diode électroluminescente 16 contre les décharges électrostatiques.

La figure 2 représente un autre mode de réalisation d'un dispositif optoélectronique 50 dans lequel l'élément de connexion 37 est remplacé par des doigts conducteurs 52, trois doigts 52 étant représentés en figure 2, qui s'étendent au travers de la portion semiconductrice 28, de la zone active 26 et d'une partie de la portion semiconductrice 24. Chaque doigt 52 est entouré d'une gaine isolante 54 qui l'isole électriquement de la portion semiconductrice 28 et de la zone active 26. L'extrémité de chaque doigt 52 est au contact de la portion semiconductrice 24.

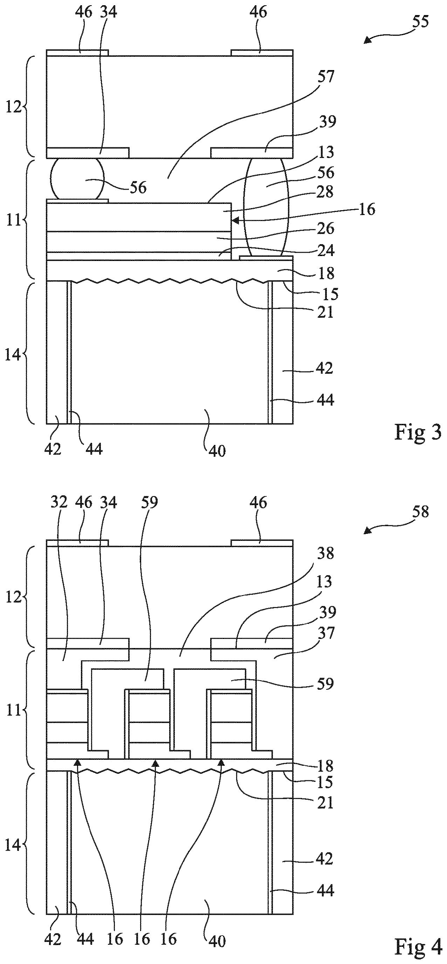

La figure 3 représente un autre mode de réalisation d'un dispositif optoélectronique 55 dans lequel la liaison entre la puce optoélectronique 11 et l'interposeur 12 est réalisée par des billes conductrices électriquement 56. De préférence, l'interstice 57 entre la puce optoélectronique 11 et l'interposeur 12 est, en outre, remplie d'un matériau isolant électriquement mais bon conducteur de la chaleur. Le matériau de remplissage peut être du graphite ou de la poudre de diamant. De préférence, l'épaisseur maximale de l'interstice 57 est inférieure à 5 µm, de préférence inférieure à 2 µm.

Dans les modes de réalisation décrits précédemment, le dispositif optoélectronique comprend une seule diode électroluminescente. A titre de variante, le dispositif optoélectronique peut comprendre plusieurs diodes électroluminescentes qui peuvent être connectées en série et/ou en parallèle.

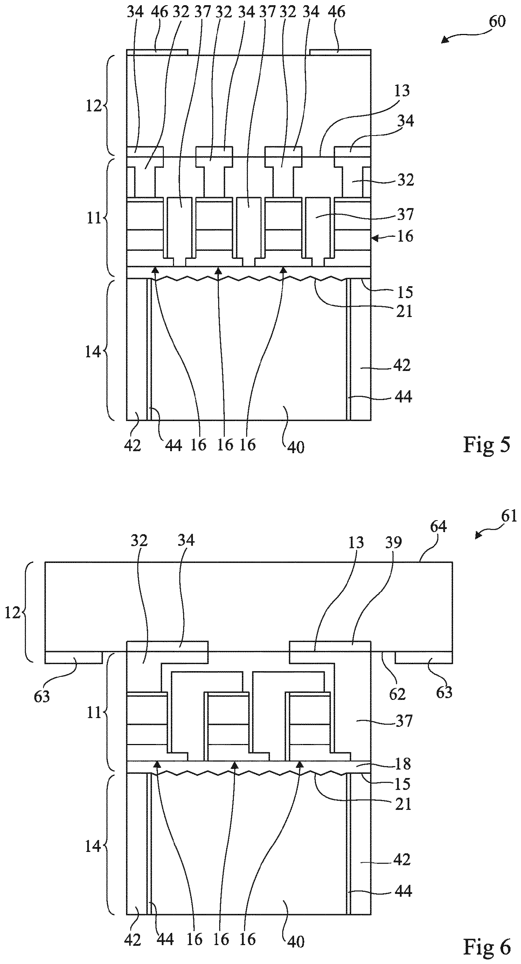

Les figures 4 et 5 illustrent des modes de réalisation dans lesquels le dispositif optoélectronique comprend plusieurs diodes électroluminescentes 16. La figure 4 représente un mode de réalisation d'un dispositif optoélectronique 58 comprenant trois diodes électroluminescentes 16 connectées en série, des éléments de connexion supplémentaires 59 permettant de connecter entre elles deux diodes électroluminescentes 16 adjacentes. La figure 5 représente un autre mode de réalisation d'un dispositif optoélectronique 60 comprenant quatre diodes électroluminescentes 16 connectées en parallèle. Sur la figure 5, les portions conductrices 39 associées à chaque diode électroluminescente 16 ne sont pas visibles.

La figure 6 représente un autre mode de réalisation d'un dispositif optoélectronique 61 dans lequel les dimensions latérales de l'interposeur 12 sont supérieures à celles de la puce optoélectronique 11. La connexion électrique de l'interposeur 12 à un autre dispositif électronique, par exemple selon une connexion par fils, peut alors être réalisée sur la face 62 de l'interposeur en contact avec la face 13 de la puce optoélectronique 11. En figure 6, on a représenté deux portions conductrices 63 sur la face 62 qui peuvent être utilisées pour une connexion électrique par fils. Ce mode de réalisation permet, de façon avantageuse, de fixer l'interposeur sur la totalité de la face 64 opposée à la face 62 sur un radiateur et ainsi améliorer l'évacuation de la chaleur produite par la puce optoélectronique 11 par l'intermédiaire de l'interposeur 12.

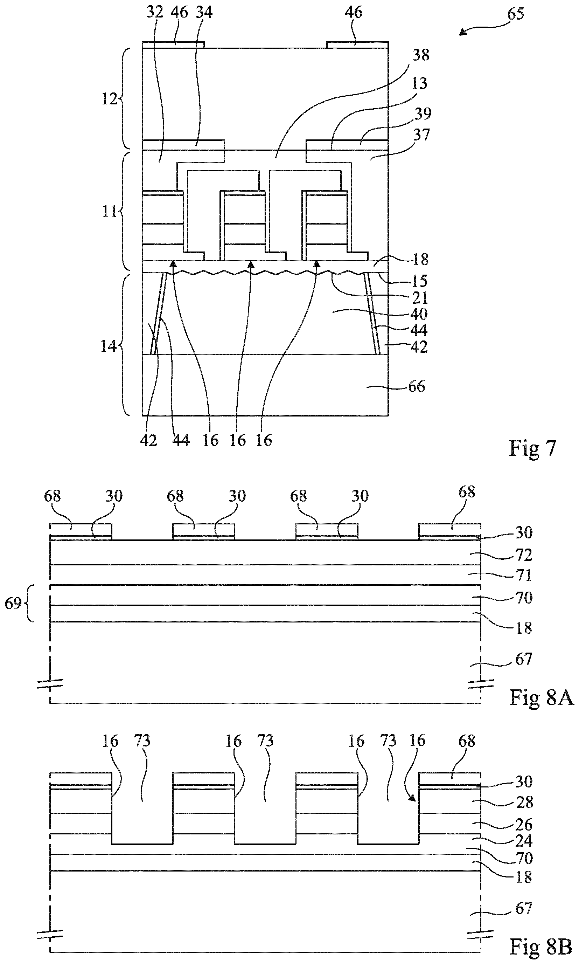

La figure 7 représente un autre mode de réalisation d'un dispositif optoélectronique 65 dans lequel le capot 14 comprend une plaque transparente 66, par exemple une plaque de verre fixée au cadre 42, le bloc photoluminescent 40 étant situé entre la puce optoélectronique 11 et la plaque transparente 66. L'épaisseur du capot 14 incluant la plaque transparente 66 est supérieure ou égale à 100 µm, de préférence supérieure à 200 µm, par exemple environ 500 µm. En figure 7, les parois latérales du cadre 42, orientées vers le bloc photoluminescent 40, sont inclinées de façon à améliorer la réflexion de la lumière fournie par les diodes électroluminescentes 16 vers l'extérieur du dispositif optoélectronique 65.

Les figures 8A à 8N illustrent un mode de réalisation d'un procédé de fabrication du dispositif optoélectronique 10 représenté en figure 1 dans lequel le procédé de formation des diodes électroluminescentes correspond à celui décrit dans la demande de brevet FR14/50077.

La figure 8A représente la structure obtenue après avoir formé, sur un substrat 67, un empilement de couches semiconductrices à partir duquel plusieurs diodes électroluminescentes 16 vont être réalisées, les portions conductrices 30 sur l'empilement et des portions diélectriques 68 sur les portions conductrices 30. Le substrat 67 peut correspondre à une structure monobloc ou correspondre à une couche recouvrant un support constitué d'un autre matériau, par exemple du verre ou du métal. Le substrat est, par exemple, un substrat semiconducteur, tel qu'un substrat en silicium, en germanium, en carbure de silicium, en un composé III-V, tel que du GaN ou du GaAs, en un composé II-VI, tel que du ZnO. De préférence, le substrat 67 est en silicium, notamment en silicium monocristallin ou polycristallin. Le substrat 67 peut être un substrat isolant, par exemple un substrat en saphir. L'épaisseur initiale de la puce optoélectronique 11 est comprise entre 200 µm et 2 mm.

L'empilement comporte, du bas vers le haut en figure 8A :
une couche semiconductrice 69 dopée de type N, par exemple à base de GaN, qui comporte une première partie plus fortement dopée formant la couche semiconductrice 18, recouvrant le substrat 67, et recouverte d'une partie moins fortement dopée formant une couche semiconductrice 70 dopée N-. A titre de variante, les deux couches 18 et 70 peuvent correspondre à deux couches de matériaux différents. A titre d'exemple, la couche 18 peut être à base de GaN et la couche 70 peut être à base d'InGaN. En outre, que les deux couches 18 et 70 correspondent à deux couches de matériaux différents ou à une seule couche d'un même matériau, les niveaux de dopage des deux couches 18 et 70 peuvent être similaires ou non ;
des couches actives 71 correspondant à un empilement alterné d'une ou de plusieurs couches émissives à puits quantique, par exemple à base d'InGaN, et de couches barrières, par exemple à base de GaN ; et
une couche semiconductrice 72, par exemple du GaN, dopée de type P.

Les portions conductrices 30 sont, par exemple, réalisées par un dépôt d'une couche de matériau électriquement conducteur, par exemple de l'aluminium ou de l'argent, suivi d'une lithographie et d'une gravure.

Les portions conductrices 30 et les portions diélectriques 68 ont chacune une forme et des dimensions, dans le plan de la face supérieure de la couche semiconductrice 72 sur laquelle elles sont réalisées, sensiblement similaires à celles souhaitées pour les diodes électroluminescentes 16, par exemple une section en forme de disque.

La figure 8B représente la structure obtenue après avoir gravé la couche semiconductrice 72, les couches actives 71, et une première partie de la couche semiconductrice 70 selon le motif défini par les portions diélectriques 67, formant, pour chaque diode électroluminescente 16, une structure mesa, par exemple de forme cylindrique, comprenant la zone active 26 disposée entre les portions semiconductrices 24 et 28. Cette gravure est arrêtée à un niveau de profondeur situé dans la couche semiconductrice 70 de façon qu'une portion de la couche 70 soit conservée au fond de chacune des zones gravées de l'empilement. L'étape de gravure forme des espaces vides 73 entre les diodes électroluminescentes 16. La gravure mise en oeuvre est une gravure sèche, par exemple via un plasma à base de Cl₂ ou une gravure ionique réactive (RIE) . La distance minimale entre deux diodes électroluminescentes est, de préférence, supérieure à 15 µm, de préférence supérieure ou égale à 20 µm.

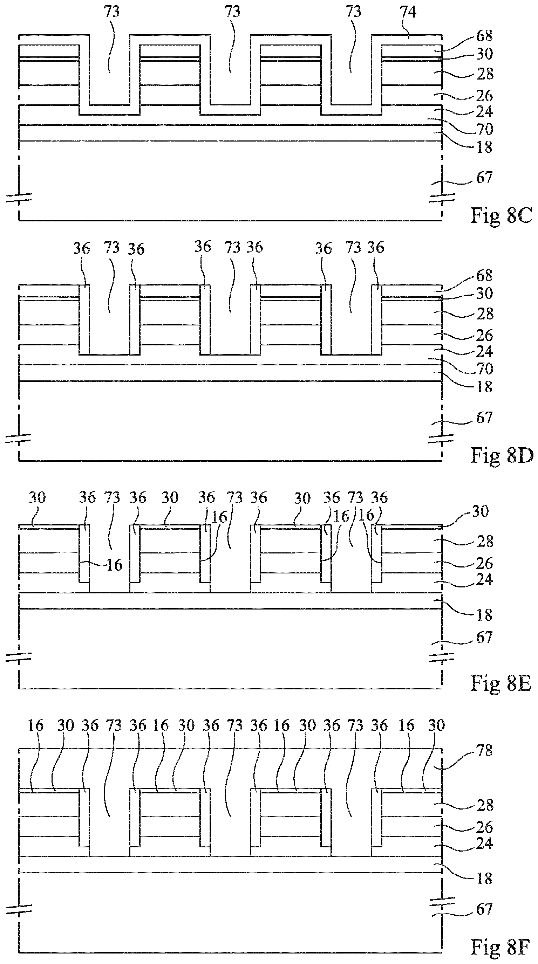

La figure 8C représente la structure obtenue après avoir déposé de façon conforme une couche diélectrique 74, par exemple à base de SiN, par exemple comprise entre environ 3 nm et 100 nm, sur les portions diélectriques 68 et le long des parois des espaces vides 73, et recouvrant donc notamment les parois latérales des portions conductrices 30, des portions semiconductrices 28, des zones actives 26 et d'une partie des portions semiconductrices 24.

La figure 8D représente la structure obtenue après avoir réalisé une gravure anisotrope, par exemple une gravure sèche, de façon à retirer les parties de la couche diélectrique 74 se trouvant au fond des espaces vides 73 et sur les portions diélectriques 68. Les portions diélectriques 36 sont ainsi obtenues.

La figure 8E représente la structure obtenue après avoir gravé le reste de la couche semiconductrice 70 au fond des espaces vides 73 jusqu'à la couche semiconductrice 18, après avoir gravé les portions diélectriques 68.

La figure 8F représente la structure obtenue après avoir déposé un matériau électriquement conducteur 78 qui remplit les espaces vides 73 et recouvre les diodes électroluminescentes 16. A titre d'exemple, le matériau conducteur 78 est formé par le dépôt conforme d'une première couche de titane d'épaisseur par exemple égale à environ 10 nm, suivi d'un dépôt d'une deuxième couche d'aluminium de façon à remplir en totalité les espaces vides 73. L'épaisseur maximale du matériau conducteur 78 entre le fond des espaces vides 73, au contact de la couche semiconductrice 18, et la face supérieure du matériau conducteur 78 est, par exemple, égale à environ 1 µm.

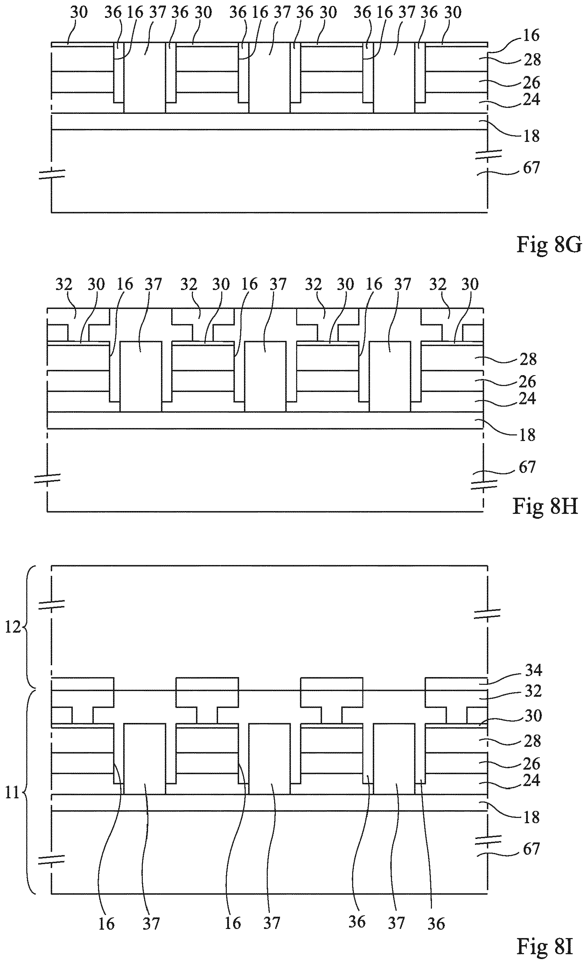

La figure 8G représente la structure obtenue après avoir réalisé une étape de planarisation, telle qu'une planarisation mécano-chimique (CMP), et/ou une étape de gravure, telle qu'une gravure RIE, du matériau conducteur électriquement 78 jusqu'à atteindre les faces supérieures des portions conductrices 30 et des portions diélectriques 36. Les portions restantes du matériau conducteur disposées entre les diodes électroluminescentes 16 correspondent aux éléments de connexion 37.

La figure 8H représente la structure obtenue après avoir formé les éléments de connexion 32 et 37.

La figure 8I représente la structure obtenue après avoir fixé l'interposeur 12 à la puce optoélectronique 11 du côté des éléments de connexion 32. L'épaisseur initiale de l'interposeur 12 est supérieure ou égale à 100 µm, par exemple comprise entre 100 µm et 10 cm. La fixation de l'interposeur 12 à la puce optoélectronique 11 peut être réalisée par collage direct, sans utilisation d'inserts tels que des microbilles de connexion. Le collage direct peut comprendre un collage direct métal-métal des zones métalliques 32 de la puce optoélectronique 11 et des zones métalliques 34 l'interposeur 12 et un collage diélectrique-diélectrique des zones diélectriques en surface de la puce optoélectronique 11 et des zones diélectriques en surface de l'interposeur 12. La fixation de l'interposeur 12 à la puce optoélectronique 11 peut être réalisée par un procédé de thermocompression dans lequel la puce optoélectronique 11 est mise en appui contre l'interposeur 12 avec application d'une pression et avec chauffage.

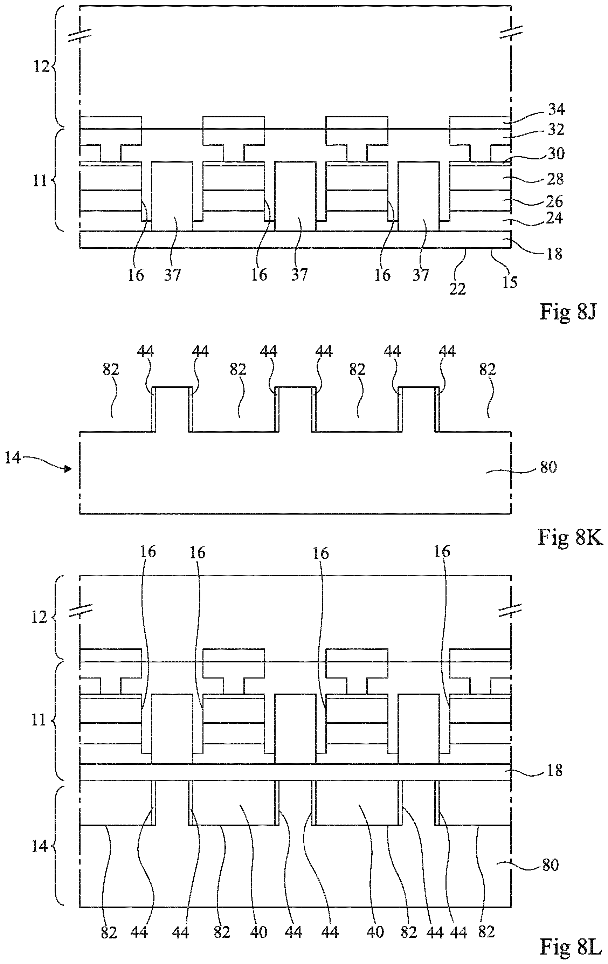

La figure 8J représente la structure obtenue après avoir retiré le substrat 67 de façon à exposer la face 15 de la couche semiconductrice 18. Lorsque le substrat 67 est en un matériau semiconducteur, le substrat 67 peut être retiré par une étape de planarisation, telle qu'une planarisation mécano-chimique (CMP), et/ou une étape de gravure, telle qu'une gravure RIE. Lorsque le substrat 67 est en un matériau isolant comme le saphir, le substrat 67 peut être retiré par ablation laser. Une étape de formation de motifs en relief sur la face 15 peut être prévue. Après l'étape d'amincissement, l'épaisseur de la puce optoélectronique 11 peut être comprise entre 100 nm et 50 µm, de préférence entre 1 µm et 30 µm, par exemple environ 10 µm.

La figure 8K illustre une étape de fabrication du capot 14 et représente la structure obtenue après avoir gravé, dans un substrat 80, des ouvertures 82 non traversantes qui sont destinées à être placées en vis-à-vis des diodes électroluminescentes 16 et après avoir recouvert les parois latérales des ouvertures 82 avec le revêtement réfléchissant 44, par exemple un film d'aluminium. Les dimensions des ouvertures 82 correspondent aux dimensions souhaitées des blocs 40 de nanocristaux semiconducteurs. Les revêtements réfléchissants 44 peuvent être formés par le dépôt d'une couche métallique sur la totalité du substrat 80 et une gravure anisotrope de la couche métallique pour ne conserver le revêtement métallique 44 que sur les parois latérales des ouvertures 82. La fabrication du capot 14 peut être réalisée indépendamment des étapes décrites précédemment. L'épaisseur initiale du capot 14 peut être supérieure ou égale à 100 µm, par exemple comprise entre 100 µm et 5 cm. A titre de variante, les ouvertures 82 peuvent être traversantes.

La figure 8L représente la structure obtenue après avoir formé les blocs 40 de nanocristaux semiconducteurs dans au moins certaines des ouvertures 82 et après avoir fixé le substrat 80 à la puce optoélectronique 11. Les blocs photoluminescents 40 peuvent être formés en remplissant certaines ouvertures 82 avec un matériau photoluminescent. Le matériau photoluminescent peut comprendre une matrice dans laquelle sont dispersées des particules photoluminescentes. Le procédé de formation des blocs 40 peut correspondre à un procédé dit additif, par exemple par impression directe du matériau photoluminescent aux emplacements souhaités, par exemple par impression par jet d'encre, héliographie, sérigraphie, flexographie, revêtement par pulvérisation (en anglais spray coating) ou dépôt de gouttes (en anglais drop-casting). La matrice du matériau photoluminescent peut être une résine que l'on fait polymériser après que le matériau photoluminescent a été déposé par impression. A titre d'exemple, la polymérisation de la matrice peut être obtenue en exposant les blocs photoluminescents 40 à un rayonnement électromagnétique, notamment un rayonnement ultraviolet. La fixation du substrat 80 à la puce optoélectronique 11 peut être réalisée par collage direct ou par thermocompression.

Dans le cas où le matériau photoluminescent n'est pas le même pour tous les blocs photoluminescents 40, le remplissage des ouvertures 82 peut être réalisé en plusieurs étapes successives, à chaque étape, des ouvertures 82 étant remplies avec un matériau photoluminescent alors que les autres ouvertures sont occultées par de la résine.

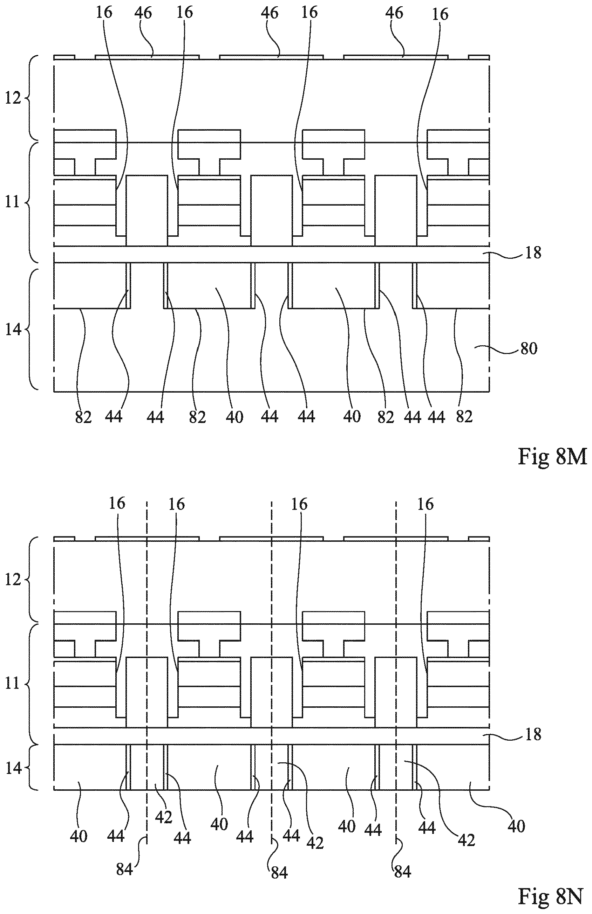

La figure 8M représente la structure obtenue après une étape d'amincissement de l'interposeur 12 et une étape de formation des portions conductrices 46 sur la face de l'interposeur 12 opposée à la puce optoélectronique 11. L'épaisseur de l'interposeur 12 après l'étape d'amincissement est inférieure ou égale à 150 µm, de préférence comprise entre 1 µm et 150 µm, plus préférentiellement comprise entre 10 µm et 100 µm par exemple environ 30 µm. La tenue mécanique de la structure est alors au moins en partie remplie par le capot 14.

La figure 8N représente la structure obtenue après une étape d'amincissement du substrat 80, depuis le coté du substrat 90 opposé aux diodes électroluminescentes 16 jusqu'à exposer les blocs 40 de nanocristaux semiconducteurs. L'amincissement peut être réalisé par planarisation mécanique et chimique. Le capot 14 peut comprendre une plaque transparente, par exemple une plaque de verre. L'épaisseur du capot 14, comprenant l'éventuelle plaque transparente, est, après l'étape d'amincissement, supérieure ou égale à 100 µm.

L'étape suivante du procédé comprend la découpe de la structure représentée en figure 8N, par exemple selon les lignes 84. Les dispositifs monolithiques obtenus après découpe ont alors chacun la structure représentée en figure 1.

Selon un autre mode de réalisation, les blocs photoluminescents 40 sont formés après l'étape de fixation du capot 14 à la puce optoélectronique 11 et l'étape d'amincissement du capot 14 dans laquelle les évidements 82 deviennent traversants.

Les modes de réalisation du procédé de fabrication du dispositif optoélectronique décrits précédemment présentent l'avantage de ne pas nécessiter l'utilisation de poignée temporaire pour la manipulation des puces de circuit intégré. Il n'y a donc pas d'étape de retrait d'une poignée temporaire. En outre, l'interposeur 12 peut être fixé à un support par exemple par une liaison de type "Flip-Chip". La connexion électrique de l'interposeur 11 peut être mise en oeuvre sans utilisation de fils de connexion.

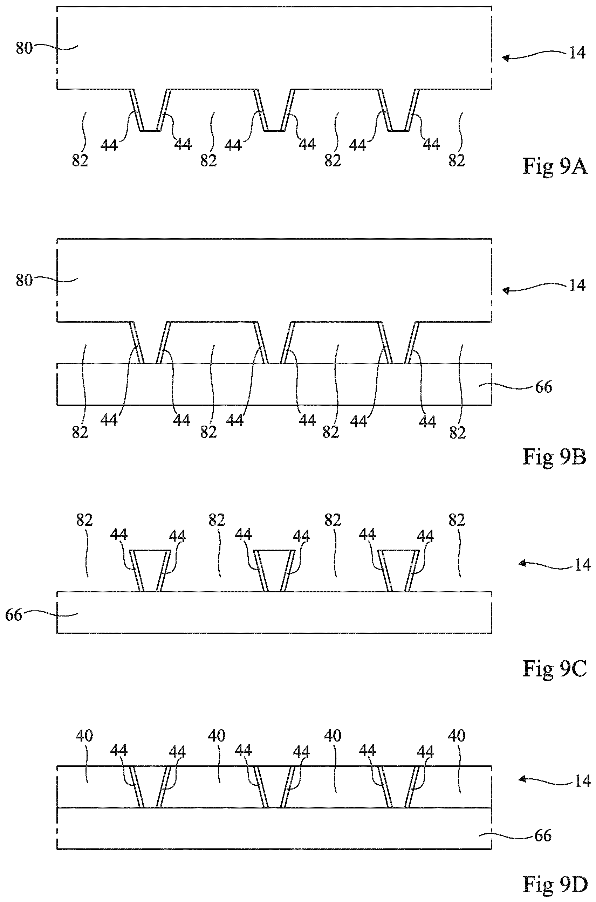

Les figures 9A à 9D sont des vues avec coupe, partielles et schématiques, de structures obtenues à des étapes successives d'un mode de réalisation d'un procédé de fabrication du capot 14 du dispositif optoélectronique 65 représenté en figure 7.

La figure 9A est une figure analogue à la figure 8K à la différence que les ouvertures 82 ont des flancs inclinés.

La figure 9B représente la structure obtenue après avoir fixé la plaque transparente 66, notamment une plaque de verre, au substrat 80, du côté des ouvertures 82, par exemple par un collage électrostatique verre/silicium.

La figure 9C représente la structure obtenue après une étape d'amincissement du substrat 80, depuis le coté du substrat 90 opposé à la plaque transparente 66, jusqu'à exposer les ouvertures 82. L'amincissement peut être réalisé par planarisation mécanique et chimique. L'épaisseur du capot 14, comprenant la plaque transparente 66, est, après l'étape d'amincissement, supérieure ou égale à 100 µm.

La figure 9D représente la structure obtenue après le remplissage des ouvertures 82 par un matériau photoluminescent pour former les blocs photoluminescents 40. Dans le cas où le matériau photoluminescent n'est pas le même pour tous les blocs photoluminescents 40, le remplissage des ouvertures 82 peut être réalisé en plusieurs étapes successives, à chaque étape, des ouvertures 82 étant remplies avec un matériau photoluminescent alors que les autres ouvertures sont occultées par de la résine.

Les étapes ultérieures du procédé comprennent la fixation du capot 14 à la puce optoélectronique 11, par exemple comme cela a été décrit précédemment en relation avec la figure 8L et la découpe de la structure obtenue. Les dispositifs monolithiques obtenus après découpe ont alors chacun un capot 14 ayant la structure représentée en figure 7.

Des modes de réalisation particuliers ont été décrits. Diverses variantes et modifications apparaîtront à l'homme de l'art. En particulier, bien que, dans les modes de réalisation décrits précédemment, chaque dispositif optoélectronique comprenne un seul bloc photoluminescent 40, il est clair que le dispositif optoélectronique peut comprendre plusieurs blocs photoluminescents, chaque bloc photoluminescent étant, par exemple, en regard d'une diode électroluminescente.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, la structure représentée en figure 6, dans laquelle la connexion électrique entre l'interposeur 12 et un autre dispositif électronique est réalisée sur la face 62 de l'interposeur 12 en contact avec la puce optoélectronique 11, peut être mise en oeuvre avec les autres modes de réalisation du dispositif optoélectronique 10, 50, 55, 58, 60 et 65 décrits en relation avec les figures 1, 2, 3, 4, 5 et 7. En outre, la structure représentée en figure 7 dans laquelle le capot 14 comprend une plaque transparente 66 peut être mise en oeuvre avec les autres modes de réalisation du dispositif optoélectronique 10, 50, 55, 58, 60 et 64 décrits en relation avec les figures 1, 2, 3, 4, 5 et 6. L'étendue de la protection conférée est déterminée par les revendications 1 à 6 qui suivent.

## Revendications

1. Procédé de fabrication de dispositifs optoélectroniques (10 ; 50 ; 55 ; 58 ; 59) à diodes électroluminescentes comprenant les étapes suivantes :
a) former une première puce de circuit intégré (11) comprenant des diodes électroluminescentes (16) ;
b) coller une deuxième puce de circuit intégré (12) à une première face (13) de la première puce de circuit intégré ;
c) réduire l'épaisseur de la première puce de circuit intégré du côté opposé à la première face jusqu'à former une deuxième face (15) opposée à la première face, la première puce de circuit intégré ayant, après l'étape c), une première épaisseur comprise entre 100 nm et 50 µm ;
d) coller, à la deuxième face, un capot (14) comprenant une plaquette de silicium (80) munie d'évidements (82) en regard des diodes électroluminescentes, le capot comprenant éventuellement, en outre, une plaque transparente (66) fixée à la plaquette de silicium, les étapes b), c) et d) étant successives ;
e) réduire l'épaisseur de la deuxième puce de circuit intégré, la deuxième puce de circuit intégré ayant une deuxième épaisseur inférieure ou égale à 150 µm après l'étape e) ;
f) réduire l'épaisseur de la plaquette de silicium (80) après l'étape e), l'épaisseur du capot, comprenant éventuellement la plaque transparente, étant supérieure ou égale à 100 µm après l'étape f), chaque évidement étant rempli d'un matériau photoluminescent ; et
g) découper la structure obtenue à l'étape f) en plusieurs dispositifs optoélectroniques distincts comprenant chacun au moins l'une des diodes électroluminescentes.

2. Procédé selon la revendication 1, dans lequel les diodes électroluminescentes (16) ont une structure mesa.

3. Procédé selon la revendication 1 ou 2, dans lequel les évidements (82) sont remplis du matériau photoluminescent avant l'étape d).

4. Procédé selon la revendication 1 ou 2, dans lequel les évidements (82) sont non traversants avant l'étape f), et sont traversants après l'étape f), le procédé comprenant, en outre, l'étape de remplissage de chaque évidement du matériau photoluminescent après l'étape f).

5. Procédé selon l'une quelconque des revendications 1 à 4, dans lequel l'étape a) comprend la formation des diodes électroluminescentes (16) sur un substrat (67) et l'étape c) comprend le retrait, partiel ou complet, du substrat.

6. Procédé selon l'une quelconque des revendications 1 à 5, dans lequel la deuxième puce de circuit intégré (12) est fixée à la première puce de circuit intégré (11) par collage direct et est reliée électriquement aux diodes électroluminescentes (16).

## Patentansprüche

1. Verfahren zur Herstellung optoelektronischer Vorrichtungen (10; 50; 55; 58; 59), die lichtemittierende Dioden aufweisen, das folgende Schritte aufweist:
a) Ausbilden eines ersten integrierten Schaltungschips (11) mit lichtemittierenden Dioden (16);
b) Bonden eines zweiten integrierten Chips (12) mit einer ersten Oberfläche (13) des ersten integrierten Schaltungschips;
c) Verringern der Dicke des ersten integrierten Schaltungschips auf der der ersten Oberfläche entgegengesetzten Seite, um eine zweite Oberfläche (15) entgegengesetzt der ersten Oberfläche auszubilden, wobei der erste integrierte Schaltungschip nach Schritt c) eine erste Dicke im Bereich von 100 nm bis 50 µm aufweist;
d) Bonden an die zweite Oberfläche einer Kappe (14), die einen Siliziumwafer (80) aufweist, der mit Ausnehmungen (82) entgegengesetzt den lichtemittierenden Dioden vorgesehen ist, wobei die Kappe ferner optional eine transparente Platte (66) aufweist, die mit dem Siliziumwafer gebondet ist, wobei die Schritte b), c) und d) aufeinanderfolgend sind;
e) Verringern der Dicke des zweiten integrierten Schaltungschips, wobei der zweite integrierte Schaltungschip eine zweite Dicke von weniger als oder gleich 150 µm nach Schritt e) aufweist;
f) Verringern der Dicke des Siliziumwafers (80) nach Schritt e), wobei die Dicke der Kappe, die optional die transparente Platte aufweist, größer oder gleich 100 µm nach Schritt f) ist, wobei jede Vertiefung mit einem photolumineszierenden Material gefüllt ist; und
g) Schneiden der bei Schritt f) erhaltenen Struktur in eine Vielzahl von separaten optoelektronischen Vorrichtungen, die jeweils wenigstens eine der lichtemittierenden Dioden aufweisen.

2. Verfahren nach Anspruch 1, wobei die lichtemittierenden Dioden (16) eine Mesastruktur aufweisen.

3. Verfahren nach Anspruch 1 oder 2, wobei die Ausnehmungen (82) vor Schritt d) mit dem photolumineszierenden Material gefüllt werden.

4. Verfahren nach Anspruch 1 oder 2, wobei die Ausnehmungen (82) vor Schritt f) geschlossen sind und nach Schritt f) durchgehend sind, wobei das Verfahren ferner den Schritt des Füllens jeder Ausnehmung mit dem photolumineszierenden Material nach Schritt f) aufweist.

5. Verfahren nach einem der Ansprüche 1 bis 4, wobei Schritt a) das Ausbilden der lichtemittierenden Dioden (16) auf einem Substrat (67) und Schritt c) das teilweise oder vollständige Entfernen des Substrats aufweist.

6. Verfahren nach einem der Ansprüche 1 bis 5, wobei der zweite integrierte Schaltungschip (12) durch direktes Bonden mit dem ersten integrierten Schaltungschip (11) gebondet und mit den lichtemittierenden Dioden (16) elektrisch verbunden wird.

## Claims

1. A method of manufacturing optoelectronic devices (10; 50; 55; 58; 59) comprising light-emitting diodes, comprising the steps of:
a) forming a first integrated circuit chip (11) comprising light-emitting diodes (16);
b) bonding a second integrated chip (12) to a first surface (13) of the first integrated circuit chip;
c) decreasing the thickness of the first integrated circuit chip on the side opposite to the first surface to form a second surface (15) opposite to the first surface, the first integrated circuit chip having, after step c), a first thickness in the range from 100 nm to 50 µm;
d) bonding, to the second surface, a cap (14) comprising a silicon wafer (80) provided with recesses (82) opposite the light-emitting diodes, the cap further optionally comprising a transparent plate (66) bonded to the silicon wafer, steps b), c) and d) being successive;
e) decreasing the thickness of the second integrated circuit chip, the second integrated circuit chip having a second thickness smaller than or equal to 150 µm after step e);
f) decreasing the thickness of the silicon wafer (80) after step e), the thickness of the cap, optionally comprising the transparent plate, being greater than or equal to 100 µm after step f), each recess being filled with a photoluminescent material; and
g) cutting the structure obtained at step f) into a plurality of separate optoelectronic devices, each comprising at least one of the light-emitting diodes.

2. The method of claim 1, wherein the light-emitting diodes (16) have a mesa structure.

3. The method of claim 1 or 2, wherein the recesses (82) are filled with the photoluminescent material before step d) .

4. The method of claim 1 or 2, wherein the recesses (82) are blind before step f), and are through after step f), the method further comprising the step of filling each recess with the photoluminescent material after step f).

5. The method of any of claims 1 to 4, wherein step a) comprises the forming of the light-emitting diodes (16) on a substrate (67) and step c) comprises the partial or total removal of the substrate.

6. The method of any of claims 1 to 5, wherein the second integrated circuit chip (12) is bonded to the first integrated circuit chip (11) by direct bonding and is electrically connected to the light-emitting diodes (16).
